Europäisches Patentamt

European Patent Office

Office européen des brevets

(11) Veröffentlichungsnummer: **0 285 846**
**A1**

# (12) EUROPÄISCHE PATENTANMELDUNG

(21) Anmeldenummer: **88103843.4**

(22) Anmeldetag: **11.03.88**

(51) Int. Cl.4: **C23C 14/56**

(30) Priorität: **31.03.87 DE 8704734 U**

(43) Veröffentlichungstag der Anmeldung:
**12.10.88 Patentblatt 88/41**

(84) Benannte Vertragsstaaten:
**DE FR GB**

(71) Anmelder: **PLASMA-ELECTRONIC GMBH + CO.**
**Fabrikstrasse 17**
**D-7024 Filderstadt 4(DE)**

(72) Erfinder: **Biersch, Gerhard**
**Eichenweg 13**
**D-7022 L.-Echterdingen(DE)**

(74) Vertreter: **Schmid, Berthold**
**Patentanwälte Dipl.-Ing. B. Schmid Dr. Ing. G. Birn Faibenhennenstrasse 17**
**D-7000 Stuttgart 1(DE)**

(54) **Vakuumkammer zur Behandlung der Oberflächen von insbesondere Substraten od. dgl. mittels ionisierter Gase.**

(57) Die bekannten Vakuumkammern (1) zur Behandlung der Oberflächen von Substraten od. dgl. mittels ionisierter Gase weisen für diese eine Zuleitung (14, 14') und eine Ableitung (19, 19') auf, wobei die Ausgänge dieser Leitungen so angeordnet sind, daß das Behandlungsgas die Vakuumkammer (1) in Querrichtung durchströmt. Hierbei verläuft der Gasstrom jedoch völlig unkontrolliert, so daß die Oberflächen der Behandlungsgegenstände ungleich beaufschlagt werden. Um eine Vakuumkammer (1) mit möglichst kleinen Abmessungen zu erreichen, in welcher die Gegenstände gleichmäßig behandelt werden, ist die Austrittsöffnung (17, 17') der Ableitung (19, 19') gegenüber der Eintrittsöffnung (10, 10') der Zuleitung (14, 14') diagonal versetzt angeordnet.

# Vakuumkammer zur Behandlung der Oberflächen von insbesondere Substraten od. dgl. mittels ionisierter Gase

Die vorliegende Erfindung betrifft eine zur Behandlung der Oberflächen von insbesondere Substraten od. dgl. mittels ionisierter Gase geeignete Vakuumkammer, an die mindestens eine der Zuführung des Behandlungsgases dienende Zuleitung und eine der Abführung des Behandlungsgases dienende Ableitung angeschlossen sind.

Vakuumkammern der zuvor angegebenen Art dienen der manigfachen Behandlung od. dgl.. So werden beispielsweise organische Bestandteile bei der Rückstandanalyse Lösungsmittelreste auf Proben oberflächen, Foto-Resist od. dgl. entfernt, Silicium-oder Calium-Arsen-Scheiben für die Mikroprozessoren geäzt und beschichtet. Auch können mittels derartiger Vakuumkammern medizinische Instrumente sterilisiert oder auch Kohlenstoff-Kontaminationsschichten entfernt werden.

Bisher hat man das Behandlungsgas in der Querrichtung durch die Vakuumkammern hindurchgeführt. Eine solche Querströmung ist jedoch insofern immer noch nachteilig, als der Gasstrom völlig unkontrolliert verläuft, was wieder eine völlig ungleichmäßige Behandlung der Oberflächen der auf einem Träger in der Vakuumkammer befindlichen Behandlungsgegenstände zur Folge hat. Auch sind besondere Verteiler-und Absaugrohre erforderlich, die sich im Innern der Vakuumkammer beiderseits des der Aufnahme des Behandlungsgutes dienenden Trägers über die gesamte Kammerhöhe erstrecken und eine entsprechenden Platz einnehmen, der wieder zur Unterbringung des Behandlungsgutes verlorengeht. Dieser große Platzbedarf erfordert dabei nicht nur wesentlich größere Vakuumpumpen, sondern auch größere Hochfrequenzgenertoren zur Ionisierung des Behandlungsgases.

Darüber hinaus ist auch schon der Vorschlag gemacht worden, das Behandlungsgas durch eine zentrale vordere Kammeröffnung zuzuführen und wieder durch eine zentrale Kammeröffnung in der Kammerrückwand abzusaugen. Durch diese Maßnahme kann zwar die Vakuumkammer kleiner gebaut werden, jedoch ist eine gleichmäßige Behandlung des Behandlungsgutes insofern immer noch nicht gewährleistet, als das Behandlungsgas bei quer-oder längsstehendem Behandlungsgut immer nur einen Teil der Oberfläche des Behandlungsgutes erreichen kann.

Aufgabe der vorliegenden Erfindung ist es nunmehr, diese bisher immer noch bestehenden Schwierigkeiten zu beseitigen und eine Gestaltung einer solchen Vakuumkammer zu schaffen, die sich einerseits durch kleine Abmessung auszeichnet, andererseits aber eine sichere und gleichmäßige Behandlung der Behandlungsgegenstände gewährleistet. Diese Aufgabe wird erfindungsgemäß dadurch gelöst, daß die Austrittsöffnung der Ableitung gegenüber der Eintrittsöffnung der Zuleitung diagonal versetzt angeordnet ist. Bei dieser erfindungsgemäßen Ausgestaltung der Vakuumkammer wird die gesamte Oberfläche der Behandlungsgegenstände, insbesondere auch der Substrate, sowohl bei deren Längs-als auch bei deren Queranordnung sicher von dem Behandlungsgas bestrichen.

Weiter hat es sich als zweckmäßig erwiesen, wenn mehrere Zu-und Ableitungen vorgesehen und deren Ein-bzw. Austrittsöffnungen dann paarweise zueinander diagonal versetzt angeordnet sind. Auch können diese Zu-und Ableitungen derart paarweise im Wechsel absperrbar sein, daß das Behandlungsgas in Intervallen einmal aus der einen Richtung und einmal aus der anderen Richtung zugeführt und abgeleitet wird, was wieder eine besondere gleichmäßige Behandlung der Oberflächen des Behandlungsgutes zur Folge hat.

Schließlich ist es auch noch möglich, die Zu-und Ableitungen derart umschaltbar an die Gaszuführung und an die Gasabführung anzuschließen, daß diese Zu-und Ableitungen wechselweise verwendbar sind.

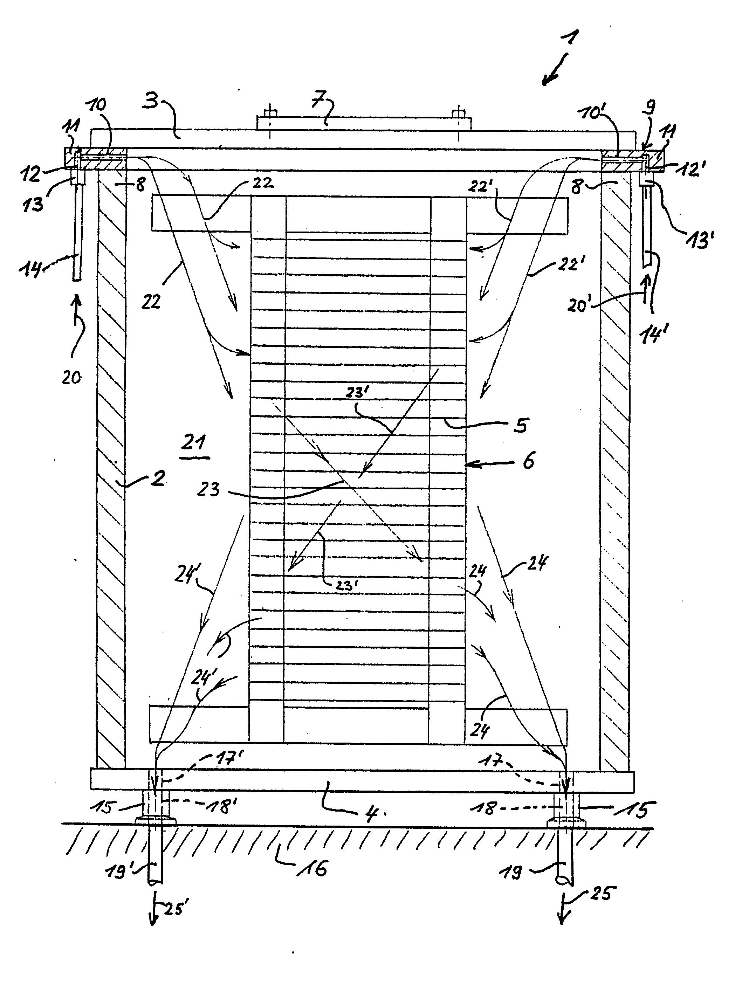

Weitere Einzelheiten der vorliegenden Erfindung ergeben sich aus der folgenden Beschreibung einer auf der Zeichnung dargestellten beispielsweisen Ausführungsform sowie den zugehörigen Ansprüchen.

Die Zeichnung zeigt in schematischet Weise den Längsschnitt einer Vakuumkammer 1, die aus einem mit 2 so bezeichneten zylindrischen Mantel, einer oberen Stirnplatte 3 und einer uneren Stirnplatte 4 zusammengesetzt ist. In der oberen Stirnplatte 3 befindet sich dabei eine nicht besonders dargestellte zentrale Öffnung, die das Einbringen und Ablegen der zu behandelnden Gegenstände auf den Sieben 5 oder Gittern eines Trägers 6 ermöglicht und durch eine Abdeckplatte 7 zu verschließen ist.

Zwischen dem oberen Rand 8 des zylindrischen Mantels 2 und der oberen Stirnplatte 3 ist ein mit 9 bezeichneter Ring eingelegt, in dem versetzt zueinander zwei oder mehr mit 10 und 10' bezeichnete Radialbohrungen eingearbeitet sind, die wieder jeweils in eine in dem überstehenden Rand 11 dieses Ringes 9 eingearbeitete Axialbohrung 12 bzw. 12' münden, die jeweils an einen Anschlußnippel 13 bzw. 13' zum Anbringen einer das Behandlungsgas zuführenden Zuleitung 14 bzw. 14' angeschlossen ist.

Wie sich weiter aus der Zeichnung ergibt, so sind in der unteren, sich über Füße 15 od. dgl. auf einem Boden 16 abstützenden Stirnplatte 4 diametral zueinander zwei axiale Bohrungen 17 und 17' eingearbeitet, die in in den Füßen 15 befindliche Axialbohrungen 18 und 18' übergehen und jeweils die Verbindung zu an diesen Füßen 15 angeschlossene, das Behandlungsgas abführende Ableitungen 19 und 19' bilden.

Wird das Behandlungsgas nun in Richtung des Pfeiles 20 durch die Zuleitung 14 zugeführt und über die Axialbohrung 12 und die anschließende Radialbohrung 10 in das Innere 21 der Vakuumkammer 1 eingeführt und die an die Bohrung 17 angeschlossene Ableitung 19 geöffnet, so strömt das Behandlungsgas in Richtung der Pfeile 22 in die Vakuumkammer 1 ein, strömt in Richtung des Pfeiles 23 diagonal an den auf den Sieben 5 aufliegenden Behandlungsgegenständen vorbei, um anschließend in Richtung der Pfeile 24 durch die in der bodenseitigen Stirnplatte 4 befindliche Bohrung 17 und über die Ableitung 19 in Richtung des Pfeiles 25 abzuströmen.

Nach einem vorbestimmtem Intervall kann beispielsweise die Zuführung des Behandlungsgases über die Zuleitung 14 unterbrochen und das Behandlungsgas sodann über die Zuleitung 14' zugeführt werden. In entsprechender Weise werden auch die Ableitung 19 geschlossen und die Ableitung 19' geöffnet. Nunmehr kann das Behandlungsgas in Richtung der Pfeile 22' in die Behandlungskammer 1 eintreten, in Richtung der Pfeile 23' an den zu behandelnden Gegenständen vorbeiströmen und schließlich in Richtung der Pfeile 24' zu der Bohrung 17' gelangen, um anschließend über diese und die Ableitung 19' die Vakuumkammer 1 zu verlassen.

Durch diesen zuvor beschriebenen wechselweisen Strömungsverlauf des Behandlungsgases wird erreicht, daß die Behandlungsgase den mit den Behandlungsgegenständen beschickten Träger 6 jeweils in die diagonaler Richtung 23 bzw. 23' durchströmen, wodurch eben eine allseitige Beaufschlagung der Behandlungsgegenstände durch das Behandlungsgas gewährleistet ist.

Diese zuvor rein schematisch behandelte Anordnung der Zuleitungen 14/14' und Ableitungen 19/19' läßt sich dabei selbstverständlich in mannigfacher Weise variieren, insbesondere dann, wenn die Vakuumkammer 1 nicht senkrecht, sondern beispielsweise auch liegend aufgestellt ist, wobei sich dann sogar die Zuleitungen 14/14' und die Ableitungen 19/19' wechselweise vertauschen lassen.

**Ansprüche**

1. Vakuumkammer zur Behandlung der Oberflächen von Substraten od. dgl. mittels ionisierter Gase, an die mindestens eine der Zuführung des Behandlungsgases dienende Zuleitung und eine der Abführung des Behandlungsgases dienende Ableitung angeschlossen sind, dadurch gekennzeichnet, daß die Austrittsöffnung (17/17') der Ableitung (19/19') gegenüber der Eintrittsöffnung (10/10') der Zuleitung (14/14') diagonal versetzt angeordnet ist.

2. Vakuumkammer nach Anspruch 1, dadurch gekennzeichnet, daß mehrere Zu-und Ableitungen (14/14', 19/19') vorgesehen und deren Ein-bzw. Austrittsöffnungen (10/10', 17/17') paarweise zueinander diagonal versetzt angeordnet sind.

3. Vakuumkammer nach Anspruch 2, dadurch gekennzeichnet, daß die Zu-und Ableitungen (14, 14', 19/19') paarweise im Wechsel absperrbar sind.

4. Vakuumkammer nach Anspruch 2 und/oder 3, dadurch gekennzeichnet, daß die Zu-und Ableitungen (14/14', 19/19') derart umschaltbar an die Gaszuführung und an die Gasabführung angeschlossen sind, daß sie wechselweise als Zu-und Ableitungen (14, 14', 19/19')bzw. als Ab-und Zuleitungen (19/19', 14/14') verwendbar sind.

## EINSCHLÄGIGE DOKUMENTE

EP 88103843.4

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | EP - A2 - 0 104 764 (ANICON, INC.) <br> * Ansprüche; Fig. 1,4,6 * <br> -- | 1 | C 23 C 14/56 |
| A | US - A - 4 548 159 (D.W.FOSTER et al.) <br> * Ansprüche; Fig. 5 * <br> -- | 1 | |
| A | US - A - 4 547 404 (B.A.CAMPBELL et al.) <br> * Ansprüche; Fig. 1,4,6 * <br> -- | 1 | |
| A | US - A - 4 539 933 (B.A.CAMPBELL et al.) <br> * Ansprüche; Fig. 1,5 * <br> ---- | 1 | |

| | | | RECHERCHIERTE SACHGEBIETE (Int Cl.4) |
|---|---|---|---|
| | | | C 23 C |

Der vorliegende Recherchenbericht wurde für alle Patentansprüche erstellt.

| Recherchenort | Abschlußdatum der Recherche | Prüfer |
|---|---|---|
| WIEN | 23-06-1988 | SLAMA |